# NEUE EUROPÄISCHE PATENTSCHRIFT

(11) **EP 3 282 586 B2**
(45) Veröffentlichungstag und Bekanntmachung des Hinweises auf die Entscheidung über den Einspruch: **15.01.2025**
(45) Hinweis auf die Patenterteilung: 12.02.2020
(21) Anmeldenummer: 17182902.1
(22) Anmeldetag: 25.07.2017
(51) Int. Cl.: H03K 17/95

(54) **INDUKTIVER NÄHERUNGSSENSOR**
INDUCTIVE PROXIMITY SENSOR
DÉTECTEUR DE PROXIMITÉ INDUCTIF

(30) Priorität: 12.08.2016 DE 102016115015
(43) Veröffentlichungstag der Anmeldung: 14.02.2018
(73) Patentinhaber: SICK AG, 79183 Waldkirch (DE)
(72) Erfinder: Thoss, Dr. Sascha, 79106 Freiburg (DE); Peter, Andreas, 79312 Emmendingen (DE); Machul, Dr. Olaf, 79294 Sölden (DE)

(56) Entgegenhaltungen:
- DE-A1- 102007 001 821
- DE-A1- 102011 004 538
- DE-A1- 19 506 339
- DE-A1- 19 731 560
- DE-B- 1 180 550
- DE-B3- 102010 041 288
- DE-T2- 69 000 465
- US-A- 5 537 041
- US-A- 5 576 624
- US-A1- 2002 005 720
- US-A1- 2002 053 908
- US-A1- 2016 076 912

## Beschreibung

Die vorliegende Erfindung betrifft einen induktiven Näherungssensor zur Detektion eines Objektes nach dem Oberbegriff von Anspruch 1 und ein Verfahren zur Detektion eines Objektes nach dem Oberbegriff von Anspruch 13.

Induktive Näherungssensoren werden als berührungslose Schalter in rauer Umgebung eingesetzt. Ein wichtiges Qualitätsmerkmal ist dabei der maximal erreichbare Schaltabstand.

Ein wichtiges Qualitätsmerkmal induktiver Sensoren ist neben der Größe eines Nennschaltabstandes SN, welcher für Stahl definiert ist, auch die Größe des realen Schaltabstandes, der bei anderen Materialien erreicht wird. Diese Schaltabstände werden durch sogenannte Reduktionsfaktoren bestimmt. Je größer der Schaltabstand bzw. der Reduktionsfaktor ist, desto besser. Idealerweise hat der Sensor den gleichen hohen Schaltabstand auf beliebige Metalle. Die Reduktionsfaktoren haben in diesem Fall den Maximalwert 1 und werden deshalb auch Faktor 1- oder F1-Sensoren genannt. Durchschnittliche induktive Sensoren haben meist nur einen zweifachen Schaltabstand, keine F1-Eigenschaft und meist Metallgehäuse mit einer Kunststoffstimseite.

Die US 2002/0053908 A1 offenbart einen Metalldetektor mit einer Sendespule, mit welcher magnetische Pulse ausgesendet werden, und ein Empfangssignal empfangen wird, wobei eine digitale Signalauswerteeinheit vorgesehen ist.

Die US 2016/0076912 A1 offenbart einen induktiven Wegmesssensor zur Abstandsmessung mit einer Sendespule, welche ein gepulstes Signal aussendet, und eine Empfangsspule zur Erfassung einer Pulsantwort, wobei eine detektierte Impulsantwort mit einem künstlichen neuronalen Netzwerk ausgewertet wird.

Die US 2003/0030566 A1 offenbart eine nach dem induktiven Wirkprinzip arbeitende Näherungs- oder Anwesenheitsschalteranordnung, welche wenigstens eine in einem Schwingkreis integrierte Induktivität und eine nachgeschaltete elektronische Steuer- bzw. Bewertungsvorrichtung beinhaltet, zur Ermittlung der Annäherung und/oder Anwesenheit eines elektromagnetische Felder beeinflussenden Materials.

Eine Aufgabe der Erfindung besteht darin, einen induktiven Näherungssensor bereitzustellen, welcher in sehr rauen Umgebungen eingesetzt werden kann, welcher einen hohen Schaltabstand aufweist und bei verschiedenen metallischen Objekten aus unterschiedlichen Metalllegierungen ein Faktor 1-Verhalten aufweist.

Eine weitere Aufgabe der Erfindung besteht darin, einen induktiven Näherungssensor bereitzustellen, der in verschiedenen Sensorgehäusen aus jeweils verschiedenen Materialien untergebracht werden kann.

Eine weitere Aufgabe besteht darin, einen induktiven Näherungssensor bereitzustellen, der vielseitig einsetzbar ist.

Die Aufgabe wird gemäß Anspruch 1 gelöst durch einen im Anspruch 1 definierten induktiven Näherungssensor.

Die Aufgabe wird weiter gelöst gemäß Anspruch 13 durch ein im Anspruch 13 definiertes Verfahren.

Gemäß der Erfindung wird der Spannungspuls bzw. ein Teil des Spannungspulses digitalisiert. Der große Vorteil besteht darin, dass dadurch viel mehr Informationen aus dem Spannungspuls gewonnen werden können, wodurch ein maximaler Informationsgehalt digital zur Verfügung steht. Dadurch weist der induktive Näherungssensor einen hohen Schaltabstand auf.

Neben dem offensichtlichen Vorteil, dass ein Objekt schon in größeren Entfemungen detektiert werden kann, hat ein hoher Schaltabstand noch weitere Vorteile. Je höher der Schaltabstand des Sensors ist, desto größer kann der potentielle Abstand zum detektierenden Objekt sein. Dadurch verringert sich die Wahrscheinlichkeit von mechanischer Zerstörung.

Ein weiterer Vorteil großer Schaltabstände ist eine größere Einbautoleranz. Dadurch muss ein Techniker bei der Montage des Sensors nicht so präzise arbeiten, was Zeit und Geld spart, sowie eine Verfügbarkeit eines Systems mit dem Sensor erhöht.

Ein weiterer Vorteil ist das Miniaturisierungspotential. Bei einem bestimmten Sensordurchmesser kann ein größerer Schaltabstand realisiert werden, bzw. bei einem bestimmen Schaltabstand kann der Sensordurchmesser verkleinert werden, wodurch konstruktive Vorteile erzielt werden.

Gemäß der Erfindung wird der Spannungspuls ab dem Zeitpunkt des Anlegens des Sendestromimpulses bis zu dem Zeitpunkt des vollständigen Abklingens des Spannungspulses digitalisiert. Es wird damit der gesamte Spannungspuls abgetastet und Abtastwerte an den Abtastpunkten erzeugt.

Durch die Analyse der gesamten Pulsantwort können jeweils unterschiedliche Objekte voneinander unterschieden werden. So können die Objekte klassifiziert werden und beispielsweise unterschiedliche Objektefeststellungssignale ausgegeben werden. Jedoch kann es auch vorgesehen sein, nur bei einem bestimmten vordefinierten Objekt ein Objektfeststellungssignal auszugeben und bei anderen Objekten kein Objektfeststellungssignal auszugeben.

Gemäß einer Ausführung weist der induktive Näherungssensor eine erste Spule als Sendespule auf und eine zweite Spule als Empfangsspule auf, wobei der Sendestromimpuls durch die Sendespule fließt und die sich ergebende Pulsspannung des Spannungspulses an der Empfangsspule gemessen wird.

Diese vorteilhafte Ausführungsform besteht darin, statt einer einzigen Spule eine Sende- und eine Empfangsspule zu verwenden. Dabei wird der Sendestromimpuls nur an der Sendespule angelegt und der Spannungspuls wird an der Empfangsspule gemessen. Diese Weiterbildung ermöglicht es, mit Hilfe der Wicklungsverhältnisse den Signal-Rausch-Abstand zu optimieren.

In Weiterbildung der Erfindung sind Schaltmittel vorhanden, wobei die erste Spule und die zweite Spule parallel schaltbar sind oder die erste Spule und die zweite Spule in Reihe schaltbar sind.

Beispielsweise können beide Spulen zum Senden parallel geschaltet werden und zum Empfangen werden die Spulen in Reihe geschaltet werden. Dadurch kann eine Empfindlichkeit des Sensors weiter erhöht werden.

Weiter kann es auch vorgesehen sein, eine einzige Spule zum Senden zu verwenden und beide Spulen in Reihe zu schalten, zum Empfangen. Auch dadurch wird eine Empfindlichkeit des Sensors erhöht.

Die Schaltmittel werden dabei von der Ansteuer- und Auswerteeinheit angesteuert. Die Schaltmittel werden dabei beispielsweise durch eine Transistorschaltung oder durch die Ansteuer-und Auswerteeinheit selbst gebildet.

Gemäß der Erfindung ist die Ansteuer- und Auswerteeinheit ausgebildet für eine Abstandsbestimmung eines metallischen Objektes die Abtastwerte von mindestens zwei Spannungspulsen auszuwerten, wobei Abtastpunkte in Bezug auf den Beginn des Spannungspulses gegeneinander verschoben sind, wodurch die zeitliche Auflösung des Spannungspulses durch die Verschiebung und eine Überlagerung erhöht ist.

Ein wichtiger Punkt besteht darin, dass die Abtastwerte mehrerer Spannungspulse, die nacheinander aufgenommen werden, miteinander kombiniert werden. Die Abtastpunkte bzw. die Abtastzeitpunkte mehrerer Spannungspulse werden leicht gegeneinander verschoben, so wird die zeitliche Auflösung über die durch die Abtastrate vorgegebene Nyquistrate hinaus gesteigert.

Dadurch lassen sich auch sehr hochfrequente Informationen aus dem Spannungspuls gewinnen, die durch die Filterwirkung einer analogen Integration verloren gehen würden.

Weiter kann durch die Vielzahl zur Verfügung stehender Abtastpunkte stärker gefiltert werden, wodurch ein Signal-Rausch-Abstand verbessert wird und eine Amplitudenauflösung steigt.

In Weiterbildung der Erfindung ist ein Anlag-/Digital-Wandler für die Abtastung des Spannungspulses vorgesehen. Der Analog-/Digital-Wandler ist beispielsweise direkt an einen Mikrocontroller angeschlossen. Der Analog-/Digital-Wandler ist Teil der Ansteuer- und Auswerteeinheit. Die Ansteuer- und Auswerteeinheit kann beispielsweise einen Mikrocontroller, einen digitalen Signalprozessor, einen digitalen Signalcontroller oder ähnliches aufweisen.

In Weiterbildung ist ein Zeit-/Digital-Wandler bzw. ein Time-to-Digital Converter für die Abtastung des Spannungspulses vorgesehen. Ein sogenannter Zeit-/Digital-Wandler ist eine elektronische Baugruppe, die sehr kurze Zeitintervalle misst und in digitale Werte umwandelt. Beispielsweise können Zeitintervalle ab 1 Nanosekunde gemessen werden.

Gemäß der Erfindung ist die Ansteuer- und Auswerteeinheit ausgebildet, mindestens einen Spannungswert zwischen zwei Spannungspulsen abzutasten und Abtastwerte zu bilden, und die Ansteuer- und Auswerteeinheit ist ausgebildet, aus diesen Abtastwerten eine Kompensation von niederfrequenten Störungen und Offsets durchzuführen.

In Weiterbildung der Erfindung ist zwischen der Spule und dem Analog-/DigitalWandler ein Verstärker zur Impedanzwandlung und Pegelanpassung vorgesehen.

Der Verstärker ist beispielsweise zwischen Empfangsspule und Analog-/DigitalWandler eingesetzt. Der Einsatz des Verstärkers hat mindestens drei Vorteile.

Erstens lässt sich mit dem Verstärker eine Impedanzwandlung vornehmen, so dass die Empfangsspule hochohmig abgegriffen werden kann. Dadurch fließt kein Strom oder nur ein sehr niedriger Strom in der Empfangsspule und es kommt zu keiner Rückwirkung auf das Objekt. Außerdem erzeugt die Abtastschaltung im Eingang des Analog-/Digital-Wandlers keine Störungen auf der Empfangsspannung, wenn ein Verstärker als Puffer verwendet wird.

Zweitens lässt sich der Verstärker auch gleich als Anti-Aliasing Filter für den Analog-/Digital-Wandler verwenden, wenn der Verstärker ein Tiefpassverhalten aufweist.

Der dritte Vorteil besteht darin, dass der Verstärker ausgebildet ist, eine Pufferung und eine Vorverstärkung durchzuführen, wodurch der Signal-Rauschabstand und damit letztendlich auch der maximal erreichbare Schaltabstand verbessert wird.

In einer bevorzugten Ausführung der Erfindung ist mindestens die Spule und die Ansteuer- und Auswerteeinheit in einem Metallgehäuse angeordnet, wobei mindestens eine Stirnseite mit der Spule eine metallische Stirnseite aufweist, welche mit einem metallischen Mantel verbunden ist.

Dadurch erhöht sich die mechanische Robustheit, nämlich eine Schlagbeständigkeit, eine Druckresistenz bzw. eine Beständigkeit gegen Abrasion bzw. Verkratzen des Sensors. Weiter wird durch das metallische Gehäuse die chemische Beständigkeit verbessert. Beispielsweise ist bei der Verwendung von Edelstahl, beispielsweise von V4A, eine Beständigkeit gegen Salzwasser und die meisten Reinigungsmitteln gegeben. Durch die Verbindung ist der Sensorkopf hermetisch dicht ausgebildet.

Die metallische Stirnseite kann dabei beispielsweise stoffschlüssig, durch Schweißen, durch Schrauben, durch Pressen oder eine vergleichbare Verbindungstechnik verbunden sein.

In Weiterbildung der Erfindung ist die Ansteuer- und Auswerteeinheit ausgebildet, mindestens einen Abtastwert aus mindestens einem Spannungspuls zur Berechnung einer Objekteigenschaft heranzuziehen.

Beispielsweise kann dadurch festgestellt werden, aus welchem Metall das detektierte Objekt besteht. Beispielsweise kann unterschieden werden, ob das Objekte aus Stahl, Edelstahl, Aluminium oder beispielsweise Buntmetall ist.

Gemäß der Erfindung ist die Ansteuer- und Auswerteeinheit ausgebildet, eine digitale Integration in einem Zeitfenster ab oder nach dem Beginn des Spannungspulses bzw. Sendestromimpulses zur Erzeugung eines Abstandsignals durchzuführen.

Das Abstandssignal enthält dabei selbst Informationen über den Abstand des Objektes, so dass diese Abstandsdaten von einer nachfolgenden Steuerung verarbeitet werden können. Das Abstandssignal kann dabei das Objektfeststellungssignal selbst sein. Jedoch kann auch vorgesehen sein, dass zu dem Objektfeststellungssignal ein zusätzliches Abstandssignal ausgegeben wird.

Die digitale Abtastung und die digitale Nachverarbeitung der Pulse erlaubt auch die Anwendung verschiedener zum Teil auch überlappender Integrationsfenster auf denselben Spannungspuls.

In einer bevorzugten Ausführungsform der Erfindung ist die Ansteuer- und Auswerteeinheit ausgebildet, ein Vorzeichen einer Differenz zwischen mindestens einem in einem Speicher gespeicherten Referenzwert und mindestens einem Abtastwert zu bilden und auszuwerten, um festzustellen, ob das Objekt ferromagnetisch ist oder nicht.

Beispielsweise kann eine Materialerkennung durchgeführt werden. Neben der digitalen Integration, die es erlaubt, ein Faktor 1-Signal bei Objekten aus Aluminium und Stahl zu generieren, ist es auch möglich, zu entscheiden, ob es sich um ein ferromagnetisches Objekt handelt oder nicht.

Dazu wird die Differenz zwischen Abtastwerten eines Spannungspulses und abgelegten Referenzwerten gebildet. Je nach Vorzeichen dieses Ergebnisses kann entschieden werden, ob es sich um ein ferromagnetisches Target handelt oder nicht.

In Weiterbildung der Erfindung ist die Ansteuer- und Auswerteeinheit ausgebildet, eine Pulshöhe, ein Pulsmaximum, den Zeitpunkt des Pulsmaximum, eine Pulslänge und/oder Nulldurchgänge des Spannungspulses zu bestimmen und auszuwerten, wodurch die Ansteuer- und Auswerteeinheit das Abstandssignal bildet.

Dadurch kann der Schaltabstand noch weiter erhöht werden, da die genannten Charakteristiken des Spannungspulses Merkmale liefern, um eine Vielzahl von Auswerteverfahren durchzuführen.

In Weiterbildung ist die Ansteuer- und Auswerteeinheit ausgebildet, eine Differenz aus zwei zeitlich nacheinander aufgenommenen Spannungspulsen zu bilden und ausgebildet daraus, das Abstandssignal zu generieren.

Zur Generierung des Sendestromimpulses ist der induktive Sensor beispielsweise an eine Spannungsquelle angeschlossen. Jedoch könnte der induktive Sensor auch batteriebetrieben sein.

Es kann vorteilhaft sein, den Sendestromimpuls mit Hilfe einer Spannungsquelle und beispielsweise einem Präzisionswiderstand zu erzeugen, da sich mit dieser Kombination sehr präzise und temperaturstabile Ströme erzeugen lassen. Dazu wird die Spannungsquelle über einen Schalter und einen Serienwiderstand durch die Ansteuer- und Auswerteeinheit mit der Spule verbunden. Anschließend wird die Spannungsquelle von der Spule abgetrennt. Dadurch entsteht eine sehr hohe Stromänderung pro Zeit (di/dt), welches zu einer starken Magnetfeldänderung führt, welche wiederum dazu führt, dass ein Wirbelstrom in einem leitfähigen Objekt induziert wird, welches sich im Detektionsbereich des Sensors befindet. Dieser Wirbelstrom induziert dann eine Spannung in der Empfangsspule, die durch die Auswerteeinheit digitalisiert wird.

In Weiterbildung der Erfindung ist ein Widerstand parallel zur Spule geschaltet ist, um die Höhe des Spannungspulses zu begrenzenund die Ansteuer- und Auswerteelektronik vor einer Zerstörung zu schützen.

Weiter vorteilhaft ist die Verwendung eines Parallelwiderstandes zur Spule. Mit dieser Maßnahme kann die Höhe und Form des Spannungspulses verändert werden. Damit kann zum einen die Ansteuer- und Auswerteeinheit vor Zerstörung durch Überspannung geschützt werden und zum anderen besteht die Möglichkeit, die Frequenzanteile des Spannungspulses zu beeinflussen. Bei Metallgehäusen ist es zum Beispiel vorteilhaft, wenn der Puls mehr niederfrequente Anteile besitzt, da diese in der Lage sind, die metallische Stirnseite bzw. die Metallfront des Sensorgehäuses zu durchdringen. Dieses Verhalten lässt sich mit einem relativ niederohmigen Parallelwiderstand erzielen.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Figur 1: einen erfindungsgemäßen induktiven Näherungssensor;
- Figur 2: einen Spannungspuls;
- Figur 3: zwei aufeinanderfolgende Spannungspulse;
- Figur 4: einen Spannungspuls mit kombinierten Abtastwerten;
- Figur 5: zwei Spannungspulse und ein Referenzwert;
- Figur 6: einen induktiven Näherungssensor in einem Metallgehäuse.

In den nachfolgenden Figuren sind identische Teile mit identischen Bezugszeichen versehen.

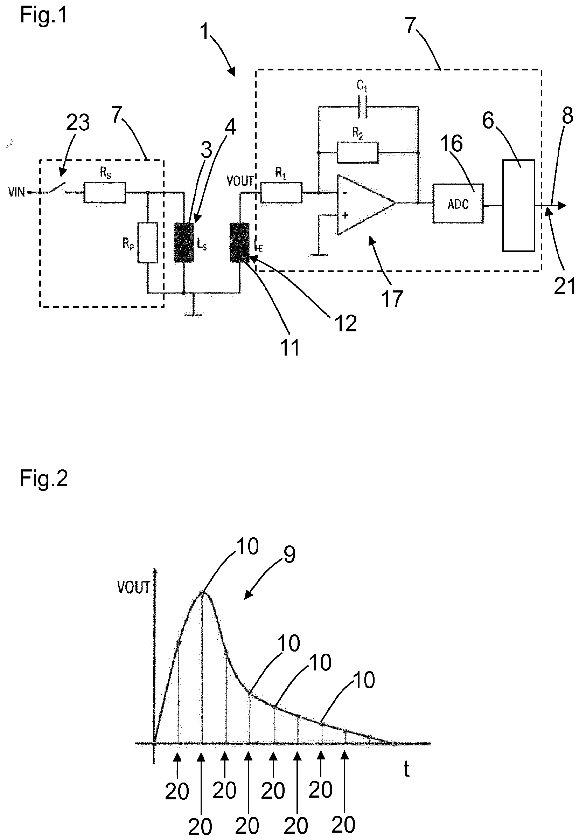

Figur 1 zeigt einen induktiven Näherungssensor 1 zur Detektion eines Objektes, mit mindestens einer Spule 3, wobei an die Spule 3 durch eine Ansteuer- und Auswerteeinheit 7 mindestens ein Sendestromimpuls angelegt wird und der Ansteuer- und Auswerteeinheit 7 zum Ausgeben eines Objektfeststellungssignals 8, wobei die Ansteuer- und Auswerteeinheit 7 ausgebildet ist, mindestens einen induzierten Spannungspuls, der durch den Sendestromimpuls an der Spule 3 erzeugt wird, in mindestens einem Abschnitt, ab oder nach dem Zeitpunkt des Anlegens des Sendestromimpulses bis zu dem Zeitpunkt des vollständigen Abklingens des Spannungspulses abzutasten und Abtastwerte zu bilden, wodurch der Spannungspuls digitalisiert wird.

Figur 2 zeigt einen Spannungspuls 9. Gemäß Figur 2 wird der Spannungspuls 9 ab oder nach dem Zeitpunkt des Anlegens des Sendestromimpulses bis zu dem Zeitpunkt des vollständigen Abklingens des Spannungspulses 9 digitalisiert. Es wird damit der gesamte Spannungspuls 9 abgetastet und Abtastwerte 10 an den Abtastpunkten 20 bzw. Abtastzeitpunkten erzeugt.

Gemäß Figur 1 weist der induktive Näherungssensor 1 die erste Spule 3 als Sendespule 4 auf und eine zweite Spule 11 als Empfangsspule 12 auf, wobei der Sendestromimpuls durch die Sendespule 4 fließt und die sich ergebende Pulsspannung des Spannungspulses an der Empfangsspule 12 gemessen wird.

Dabei wird der Sendestromimpuls nur an der Sendespule 4 angelegt und der Spannungspuls wird an der Empfangsspule 12 gemessen.

Gemäß Figur 1 ist ein Anlag-/Digital-Wandler 16 für die Abtastung des Spannungspulses vorgesehen. Der Analog-/Digital-Wandler 16 ist beispielsweise direkt an einen Mikrocontroller 6 der Ansteuer- und Auswerteeinheit 7 angeschlossen. Die Ansteuer- und Auswerteeinheit 7 kann beispielsweise statt eines Mikrocontrollers 6 auch einen digitalen Signalprozessor, einen digitalen Signalcontroller oder ähnliches aufweisen.

Gemäß Figur 1 ist die Ansteuer- und Auswerteeinheit 7 ausgebildet, Spannungswerte zwischen zwei Spannungspulsen abzutasten und Abtastwerte zu bilden und die Ansteuer- und Auswerteeinheit 7 ist ausgebildet, aus diesen Abtastwerten eine Kompensation von niederfrequenten Störungen und Offsets durchzuführen.

Gemäß Figur 1 ist zwischen der Spule 3 und dem Analog-/Digital-Wandler 16 ein Verstärker 17 zur Impedanzwandlung und Pegelanpassung vorgesehen, wobei weitere Bauteile, wie beispielsweise Widerstände oder beispielsweise die Empfangsspule, ebenfalls zwischen dem Analog-/Digital-Wandler 16 und der Spule 3 angeordnet sind.

Der Verstärker 17 ist beispielsweise zwischen Empfangsspule 12 und Analog-/DigitalWandler 16 eingesetzt. Die Verstärkung lässt sich mit den Widerständen R1 und R2 einstellen. Die Kombination aus dem Widerstand R2 und dem Kondensator C1 bestimmt die Grenzfrequenz des gebildeten Tiefpassfilters.

Erstens lässt sich mit dem Verstärker 17 eine Impedanzwandlung vornehmen, so dass die Empfangsspule 12 hochohmig abgegriffen werden kann. Dadurch fließt kein Strom oder nur ein sehr niedriger Strom in der Empfangsspule 12 und es kommt zu keiner Rückwirkung auf das Objekt. Außerdem erzeugt die Abtastschaltung im Eingang des Analog-/Digital-Wandlers 16 keine Störungen auf der Empfangsspannung, wenn ein Verstärker 17 als Puffer verwendet wird.

Zweitens lässt sich der Verstärker 17 auch gleich als Anti-Aliasing Filter für den Analog-/Digital-Wandler 16 verwenden, wenn der Verstärker 17 ein Tiefpassverhalten aufweist.

Der dritte Vorteil besteht darin, dass der Verstärker 17 ausgebildet ist, eine Pufferung und eine Vorverstärkung durchzuführen, wodurch der Signal-Rauschabstand und damit letztendlich auch der maximal erreichbare Schaltabstand verbessert wird.

Gemäß Figur 1 ist die Ansteuer- und Auswerteeinheit 7 ausgebildet, mindestens einen Abtastwert aus mindestens einem Spannungspuls zur Berechnung einer Objekteigenschaft heranzuziehen.

Gemäß Figur 1 ist die Ansteuer- und Auswerteeinheit 7 ausgebildet, eine digitale Integration in einem Zeitfenster ab Beginn des Spannungspulses bzw. Strompulses zur Erzeugung eines Abstandsignals 21 durchzuführen.

Das Abstandssignal 21 enthält dabei selbst Informationen über den Abstand des Objektes, so dass diese Abstandsdaten von einer nachfolgenden Steuerung verarbeitet werden können.

Gemäß Figur 1 sind zur Generierung eines Sendestrompulses ein Widerstand RS und ein Schalter 23 vorgesehen.

Neben der Verwendung einer Stromquelle zur Pulserzeugung kann es vorteilhaft sein, den Sendestromimpuls mit Hilfe einer Spannungsversorgung und einem Präzisionswiderstand zu erzeugen, da sich mit dieser Kombination sehr präzise und temperaturstabile Ströme erzeugen lassen. Dazu wird die Spannungsversorgung über einen Schalter 23 und einen Serienwiderstand RS mit der Spule 3 verbunden. Anschließend wird die Spannungsversorgung von der Spule 3 abgetrennt. Dadurch entsteht eine sehr hohe Stromänderung pro Zeit (di/dt), welche zu einer starken Magnetfeldänderung führt, welche wiederum dazu führt, dass ein Wirbelstrom in einem leitfähigen Objekt induziert wird, welches sich im Detektionsbereich des Sensors befindet. Dieser Wirbelstrom induziert dann eine Spannung in der Empfangsspule 12, die durch die Ansteuer- und Auswerteeinheit 7 digitalisiert wird.

Gemäß Figur 1 ist ein Widerstand RP parallel zur Spule 3 geschaltet ist, um eine Höhe des Spannungspulses zu begrenzen. Mit dieser Maßnahme kann die Höhe und Form des Spannungspulses verändert werden. Damit kann zum einen die Ansteuer- und Auswerteeinheit 7 vor Zerstörung durch Überspannung geschützt werden und zum anderen besteht die Möglichkeit, die Frequenzanteile des Spannungspulses zu beeinflussen.

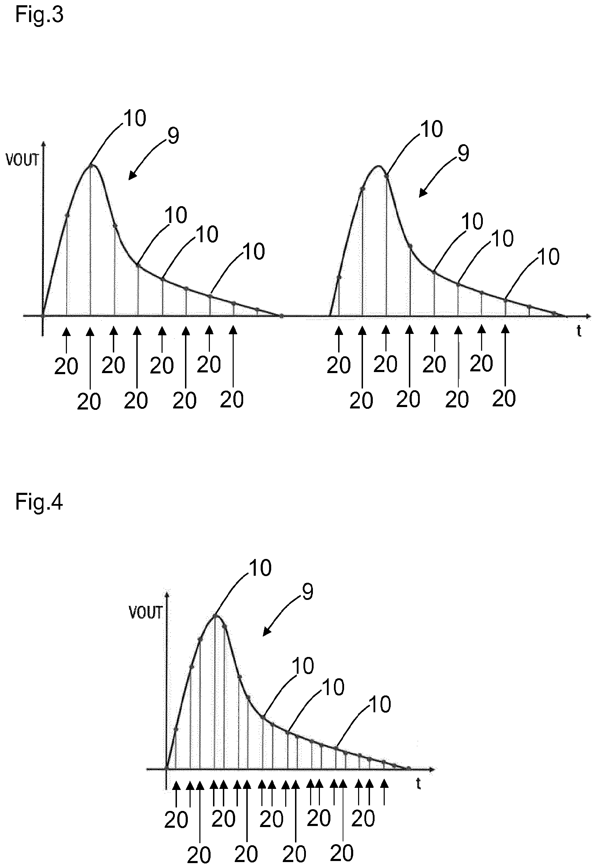

Gemäß Figur 3 ist die Ansteuer- und Auswerteeinheit ausgebildet, für eine Abstandsbestimmung eines metallischen Objektes die Abtastwerte 10 von mindestens zwei Spannungspulsen 9 auszuwerten, wobei Abtastpunkte 20 bzw. Abtastzeitpunkte in Bezug auf den Beginn des Spannungspulses 9 gegeneinander verschoben sind, wie in Figur 4 dargestellt, wodurch die zeitliche Auflösung des Spannungspulses 9 durch die Verschiebung und eine Überlagerung erhöht ist.

Gemäß Figur 4 werden die Abtastwerte 10 mehrerer Spannungspulse 9, die nacheinander aufgenommen werden, miteinander kombiniert. Die Abtastpunkte 20 bzw. Abtastzeitpunkte mehrerer Spannungspulse 9 werden leicht gegeneinander verschoben, so wird die zeitliche Auflösung über die durch die Abtastrate vorgegebene Nyquistrate hinaus gesteigert.

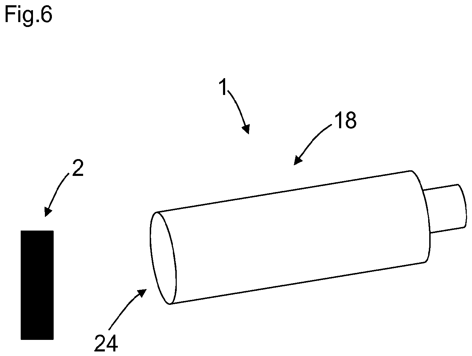

Gemäß Figur 6 ist mindestens die Spule und die Ansteuer- und Auswerteeinheit in einem Metallgehäuse 18 angeordnet, wobei mindestens eine Stirnseite 24 mit der Spule eine metallische Stirnseite 24 aufweist, welche mit einem metallischen Mantel verbunden ist. Das Objekt 2 befindet sich vor dem induktiven Näherungssensor 1.

Dadurch erhöht sich die mechanische Robustheit, nämlich eine Schlagbeständigkeit, eine Druckresistenz bzw. eine Beständigkeit gegen Abrasion bzw. Verkratzen des induktiven Näherungssensors 1. Weiter wird durch das metallische Gehäuse bzw. das Metallgehäuse 18 die Robustheit und die chemische Beständigkeit verbessert. Durch die Verbindung ist der Sensorkopf hermetisch dicht ausgebildet.

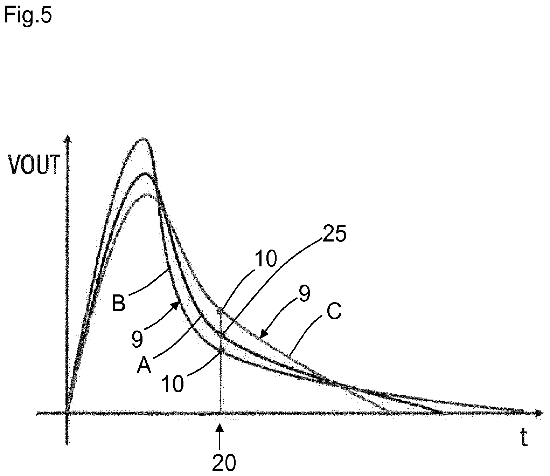

Figur 5 zeigt drei Kurven. Kurve A ist eine Kurve mit Referenzwerten ohne Objektdetektion. Die Kurven B und C sind Kurven mit Abtastwerten bei jeweils unterschiedlichen Objekten.

Gemäß Figur 5 ist die Ansteuer- und Auswerteeinheit ausgebildet, ein Vorzeichen einer Differenz zwischen mindestens einem in einem Speicher gespeicherten Referenzwert 25 und mindestens einem Abtastwert 10 zu bilden und auszuwerten, um festzustellen, ob das Objekt ferromagnetisch ist oder nicht.

Dazu wird die Differenz zwischen Abtastwerten 10 eines Spannungspulses 9 und abgelegten Referenzwerten 25 gebildet. Je nach Vorzeichen dieses Ergebnisses kann entschieden werden, ob es sich um ein ferromagnetisches Target handelt oder nicht.

Gemäß Figur 5 ist die Ansteuer- und Auswerteeinheit ausgebildet, eine Pulshöhe, ein Pulsmaximum, den Zeitpunkt des Pulsmaximum, eine Pulslänge und/oder Nulldurchgänge des Spannungspulses 9 zu bestimmen und auszuwerten, wodurch die Ansteuer- und Auswerteeinheit das Abstandssignal bildet.

Gemäß Figur 5 ist die Ansteuer- und Auswerteeinheit ausgebildet, eine Differenz aus zwei zeitlich nacheinander aufgenommenen Spannungspulsen 9 zu bilden, und ausgebildet daraus, das Abstandssignal zu generieren.

### Bezugszeichen:

- 1: Induktiver Näherungssensor
- 2: Objekt
- 3: Spule, erste Spule
- 4: Sendespule
- 6: Mikrocontroller
- 7: Ansteuer- und Auswerteeinheit
- 8: Objektfeststellungssignal
- 9: Spannungspuls,
- 10: Abtastwerte
- 11: zweite Spule
- 12: Empfangsspule
- 16: Analog/Digital-Wandler
- 17: Verstärker
- 18: Metallgehäuse
- 20: Abtastpunkte
- 21: Abstandssignal
- 23: Schalter
- 24: Stirnseite
- 25: Referenzwert

## Patentansprüche

1. Induktiver Näherungssensor zur Detektion eines Objektes (2) mit mindestens einer Spule (3), wobei an die Spule durch eine Ansteuer- und Auswerteeinheit (7) mindestens ein Sendestromimpuls anlegbar ist, und die Ansteuer- und Auswerteeinheit (7) zum Ausgeben eines Objektfeststellungssignals (8) ausgebildet ist, wobei
die Ansteuer- und Auswerteeinheit (7) ausgebildet ist, mindestens einen induzierten Spannungspuls (9), der durch den Sendestromimpuls an der Spule (3) erzeugt ist, in mindestens einem Abschnitt ab oder nach dem Zeitpunkt des Anlegens des Sendestromimpulses, bis zu dem Zeitpunkt des vollständigen Abklingens des Spannungspulses (9), abzutasten und Abtastwerte (10) von dem Spannungspuls zu bilden, wodurch der Spannungspuls (9) digitalisiert ist, wobei die Ansteuer- und Auswerteeinheit (7) ausgebildet ist, für eine Abstandsbestimmung eines metallischen Objektes (2) die Abtastwerte (10) von mindestens zwei aufeinanderfolgenden Spannungspulsen (9) auszuwerten, wobei Abtastpunkte (20) in Bezug auf den Beginn des Spannungspulses (9) gegeneinander verschoben sind, wodurch die zeitliche Auflösung des Spannungspulses (9) durch die Verschiebung und eine Überlagerung erhöht ist, wobei die Ansteuer- und Auswerteeinheit (7) ausgebildet ist, eine digitale Integration in einem Zeitfenster ab oder nach Beginn des Spannungspulses (9) oder des Sendestromimpulses zur Erzeugung eines Abstandsignals (21) durchzuführen, **dadurch gekennzeichnet, dass** die Ansteuer- und Auswerteeinheit (7) ausgebildet ist, mindestens einen Spannungswert zwischen zwei Spannungspulsen (9) abzutasten und Abtastwerte (10) von dem Spannungswert zwischen zwei Spannungspulsen zu bilden und die Ansteuer- und Auswerteeinheit (7) ausgebildet ist, aus diesen Abtastwerten (10) eine Kompensation von niederfrequenten Störungen und Offsets durchzuführen.

2. Induktiver Näherungssensor nach Anspruch 1,
**dadurch gekennzeichnet,**
**dass** der Spannungspuls (9) ab dem Zeitpunkt des Anlegens des Sendestromimpulses bis zu dem Zeitpunkt des vollständigen Abklingens des Spannungspulses (9) digitalisiert ist.

3. Induktiver Näherungssensor nach mindestens einem der vorhergehenden Ansprüche,
**dadurch gekennzeichnet,**
**dass** der induktive Näherungssensor (1) eine erste Spule (3) als Sendespule (4) aufweist und eine zweite Spule (11) als Empfangsspule (12) aufweist, wobei der Sendestromimpuls durch die Sendespule (4) fließt und die sich ergebende Pulsspannung des Spannungspulses (9) an der Empfangsspule (12) messbar ist.

4. Induktiver Näherungssensor nach Anspruch 3,
**dadurch gekennzeichnet,**
**dass** Schaltmittel vorhanden sind, wobei die erste Spule (3) und die zweite Spule (11) parallel schaltbar sind oder die erste Spule (3) und die zweite Spule (11) in Reihe schaltbar sind.

5. Induktiver Näherungssensor nach mindestens einem der vorhergehenden Ansprüche,
**dadurch gekennzeichnet,**
**dass** ein Analog-/Digital-Wandler für die Abtastung des Spannungspulses vorgesehen ist oder ein Zeit-/Digital-Wandler oder ein Time-to-Digital Converter für die Abtastung des Spannungspulses vorgesehen ist oder zwischen der Spule (3) und einem Analog/Digital-Wandler (16) ein Verstärker (17) zur Impedanzwandlung und Pegelanpassung vorgesehen ist.

6. Induktiver Näherungssensor nach mindestens einem der vorhergehenden Ansprüche,
**dadurch gekennzeichnet,**
**dass** mindestens die Spule (3) und die Ansteuer- und Auswerteeinheit (7) in einem Metallgehäuse (18) angeordnet ist, wobei mindestens eine Stirnseite mit der Spule (3) eine metallische Stirnseite aufweist welche mit einem metallischen Mantel verbunden ist.

7. Induktiver Näherungssensor nach mindestens einem der vorhergehenden Ansprüche,
**dadurch gekennzeichnet,**
**dass** die Ansteuer- und Auswerteeinheit (7) ausgebildet ist, mindestens einen Abtastwert (10) aus mindestens einem Spannungspuls (9) zur Berechnung einer Objekteigenschaft heranzuziehen.

8. Induktiver Näherungssensor nach mindestens einem der vorhergehenden Ansprüche,
**dadurch gekennzeichnet,**
**dass** die Ansteuer- und Auswerteeinheit (7) ausgebildet ist, ein Vorzeichen einer Differenz zwischen mindestens einem in einem Speicher (19) gespeicherten Referenzwert und mindestens einem Abtastwert (10) zu bilden und auszuwerten, um festzustellen, ob das Objekt (2) ferromagnetisch ist oder nicht.

9. Induktiver Näherungssensor nach mindestens einem der vorhergehenden Ansprüche,
**dadurch gekennzeichnet,**
**dass** die Ansteuer- und Auswerteeinheit (7) ausgebildet ist, eine Pulshöhe, eine Pulslänge und/oder Nulldurchgänge des Spannungspulses (9) auszuwerten, wodurch die Ansteuer- und Auswerteeinheit (7) das Abstandssignal (21) bilden.

10. Induktiver Näherungssensor nach mindestens einem der vorhergehenden Ansprüche,
**dadurch gekennzeichnet,**
**dass** die Ansteuer- und Auswerteeinheit (7) ausgebildet ist, eine Differenz aus zwei zeitlich nacheinander aufgenommenen Spannungspulsen (9) zu bilden und ausgebildet ist, daraus das Abstandssignal (21) zu generieren.

11. Induktiver Näherungssensor nach mindestens einem der vorhergehenden Ansprüche,
**dadurch gekennzeichnet,**
**dass** zur Generierung eines Strompulses eine Spannungsquelle und ein Widerstand verwendet werden und/oder ein Widerstand parallel zur Spule (3) geschaltet ist, um eine Höhe des Spannungspulses (9) zu begrenzen, um die Ansteuer-und Auswerteelektronik (7) vor einer Zerstörung zu schützen.

12. Verfahren zur Detektion eines Objektes (2) mit einem induktiven Näherungssensor, mit mindestens einer Spule (3), wobei an die Spule (3) durch eine Ansteuer- und Auswerteeinheit (7) mindestens ein Sendestromimpuls angelegt wird und die Ansteuer- und Auswerteeinheit (7) zum Ausgeben eines Objektfeststellungssignals (8) ausgebildet ist,
wobei mindestens ein induzierter Spannungspuls (9), der durch den Sendestromimpuls an der Spule (3) erzeugt wird, in mindestens einem Abschnitt ab oder nach dem Zeitpunkt des Anlegens des Sendestromimpulses bis zu dem Zeitpunkt des vollständigen Abklingens des Spannungspulses (9) abgetastet wird und Abtastwerte (10) von dem Spannungspuls gebildet werden, wodurch der Spannungspuls (9) digitalisiert wird, wobei die Ansteuer- und Auswerteeinheit (7) ausgebildet ist, für eine Abstandsbestimmung eines metallischen Objektes (2) die Abtastwerte (10) von mindestens zwei aufeinanderfolgenden Spannungspulsen (9) auszuwerten, wobei Abtastpunkte (20) in Bezug auf den Beginn des Spannungspulses (9) gegeneinander verschoben sind, wodurch die zeitliche Auflösung des Spannungspulses (9) durch die Verschiebung und eine Überlagerung erhöht ist, wobei die Ansteuer- und Auswerteeinheit (7) ausgebildet ist, eine digitale Integration in einem Zeitfenster ab oder nach Beginn des Spannungspulses (9) oder des Sendestromimpulses zur Erzeugung eines Abstandsignals (21) durchzuführen, **dadurch gekennzeichnet, dass** die Ansteuer- und Auswerteeinheit (7) ausgebildet ist, mindestens einen Spannungswert zwischen zwei Spannungspulsen (9) abzutasten und Abtastwerte (10) von dem Spannungswert zwischen zwei Spannungspulsen zu bilden und die Ansteuer- und Auswerteeinheit (7) ausgebildet ist, aus diesen Abtastwerten (10) eine Kompensation von niederfrequenten Störungen und Offsets durchzuführen.

## Claims

1. An inductive proximity sensor for detecting an object (2) having at least one coil (3), wherein at least one transmission current pulse can be applied to the coil by a control and evaluation unit (7) and the control and evaluation unit (7) is configured to output an object detection signal (8), wherein
the control and evaluation unit (7) is configured to scan at least one induced voltage pulse (9) that is generated by the transmission current pulse at the coil (3) in at least one period from or after the point in time of the application of the transmission current pulse up to the point in time of the complete attenuation of the voltage pulse (9) and to form scan values (10) from the voltage pulse, whereby the voltage pulse (9) is digitized; wherein
the control and evaluation unit (7) is configured to evaluate the scan values (10) of at least two consecutive voltage pulses (9) for a distance determination of a metallic object (2); with scan points (20) being displaced with respect to one another with respect to the start of the voltage pulse (9), whereby the time resolution of the voltage pulse (9) is increased by the displacement and a superposition and wherein the control and evaluation unit (7) is configured to carry out a digital integration in a time window from or after the start of the voltage pulse (9) or of the transmission current pulse to generate a distance signal (21),
**characterized in that**
the control and evaluation unit (7) is configured to scan at least one voltage value between two voltage pulses (9) and to form scan values (10) from the voltage value between two voltage pulses; and **in that** the control and evaluation unit (7) is configured to carry out a compensation of low frequency interference and offsets from these scan values (10).

2. An inductive proximity sensor in accordance with claim 1,
**characterized in that**
the voltage pulse (9) is digitized from the point in time of the application of the transmission current pulse up to the point in time of the complete attenuation of the voltage pulse (9).

3. An inductive proximity sensor in accordance with at least one of the preceding claims,
**characterized in that**
the inductive proximity sensor (1) has a first coil (3) as a transmitter coil (4) and a second coil (11) as a receiver coil (12), with the transmission current pulse flowing through the transmitter coil (4) and the resulting pulse voltage of the voltage pulse (9) being measurable at the receiver coil (12).

4. An inductive proximity sensor in accordance with claim 3,
**characterized in that**
switching means are present, with the first coil (3) and the second coil (11) being connectable in parallel or with the first coil (3) and the second coil (11) being connectable in series.

5. An inductive proximity sensor in accordance with at least one of the preceding claims,
**characterized in that**
an analog-to-digital converter is provided for the scanning of the voltage pulse or a time-to-digital converter is provided for the scanning of the voltage pulse or an amplifier (17) is provided between the coil (3) and an analog-to-digital converter (16) for impedance conversion and level adaptation.

6. An inductive proximity sensor in accordance with at least one of the preceding claims,
**characterized in that**
at least the coil (3) and the control and evaluation unit (7) are arranged in a metal housing (18), with at least one end face having the coil (3) having a metallic end face that is connected to a metallic jacket.

7. An inductive proximity sensor in accordance with at least one of the preceding claims,
**characterized in that**
the control and evaluation unit (7) is configured to use at least one scan value (10) from at least one voltage pulse (9) for calculating an object property.

8. An inductive proximity sensor in accordance with at least one of the preceding claims,
**characterized in that**
the control and evaluation unit (7) is configured to form and evaluate a sign of a difference between at least one reference value stored in a memory (19) and at least one scan value (10) to determine whether the object is ferromagnetic or not.

9. An inductive proximity sensor in accordance with at least one of the preceding claims,
**characterized in that**
the control and evaluation unit (7) is configured to evaluate a pulse level, a pulse length and/or zero crossings of the voltage pulse (9), whereby the control and evaluation unit (7) forms the distance signal (21).

10. An inductive proximity sensor in accordance with at least one of the preceding claims,
**characterized in that**
the control and evaluation unit (7) is configured to form a difference from two voltage pulses (9) recorded after one another in time and is configured to generate the distance signal (21) therefrom.

11. An inductive proximity sensor in accordance with at least one of the preceding claims,
**characterized in that** a voltage source and a resistor are used to generate a current pulse; and/or **in that** a resistor is connected in parallel with the coil (3) to restrict a level of the voltage pulse (9) to protect the control and evaluation electronics (7) from destruction.

12. A method of detecting an object (2) using an inductive proximity sensor, having at least one coil (3), wherein at least one transmission current pulse is applied to the coil (3) by a control and evaluation unit (7) and the control and evaluation unit (7) is configured to output an object detection signal (8), wherein
at least one induced voltage pulse (9) that is generated by the transmission current pulse at the coil (3) is scanned in at least one period from or after the point in time of the application of the transmission current pulse up to the point in time of the complete attenuation of the voltage pulse (9) and scan values (10) are formed from the voltage pulse, whereby the voltage pulse (9) is digitized,
wherein the control and evaluation unit (7) is configured to evaluate the scan values (10) of at least two consecutive voltage pulses (9) for a distance determination of a metallic object (2), with scan points (20) being displaced with respect to one another with respect to the start of the voltage pulse (9), whereby the time resolution of the voltage pulse (9) is increased by the displacement and a superposition and wherein the control and evaluation unit (7) is configured to carry out a digital integration in a time window from or after the start of the voltage pulse (9) or of the transmission current pulse to generate a distance signal (21),
**characterized in that**
the control and evaluation unit (7) is configured to scan at least one voltage value between two voltage pulses (9) and to form scan values (10) from the voltage value between two voltage pulses; and **in that** the control and evaluation unit (7) is configured to carry out a compensation of low frequency interference and offsets from these scan values (10).

## Revendications

1. Détecteur de proximité inductif pour la détection d'un objet (2), comportant au moins une bobine (3), dans lequel
au moins une impulsion de courant d'émission peut être appliquée à la bobine par une unité de pilotage et d'évaluation (7), et l'unité de pilotage et d'évaluation (7) est réalisée pour délivrer un signal de constatation d'objet (8), l'unité de pilotage et d'évaluation (7) est réalisée pour échantillonner au moins une impulsion de tension induite (9), générée par l'impulsion de courant d'émission au niveau de la bobine (3), dans au moins un intervalle à partir ou après l'instant de l'application de l'impulsion de courant d'émission jusqu'à l'instant de la décroissance complète de l'impulsion de tension (9), et pour former des valeurs échantillonnées (10) de l'impulsion de tension, moyennant quoi l'impulsion de tension (9) est numérisée,
en vue d'une détermination de la distance d'un objet métallique (2), l'unité de pilotage et d'évaluation (7) est réalisée pour évaluer les valeurs échantillonnées (10) d'au moins deux impulsions de tension successives (9), des points d'échantillonnage (20) étant décalés les uns des autres par rapport au début de l'impulsion de tension (9), moyennant quoi la résolution temporelle de l'impulsion de tension (9) est augmentée par le décalage et par une superposition et l'unité de pilotage et d'évaluation (7) est réalisée pour effectuer une intégration numérique dans une fenêtre temporelle à partir ou après le début de l'impulsion de tension (9) ou de l'impulsion de courant d'émission afin de générer un signal de distance (21),
**caractérisé en ce que**
l'unité de pilotage et d'évaluation (7) est réalisée pour échantillonner au moins une valeur de tension entre deux impulsions de tension (9) et pour former des valeurs échantillonnées (10) de la valeur de tension entre deux impulsions de tension, et l'unité de pilotage et d'évaluation (7) est réalisée pour effectuer à partir de ces valeurs échantillonnées (10) une compensation de décalages et de perturbations à basse fréquence.

2. Détecteur de proximité inductif selon la revendication 1,
**caractérisé en ce que**
l'impulsion de tension (9) est numérisée à partir de l'instant de l'application de l'impulsion de courant d'émission jusqu'à l'instant de la décroissance complète de l'impulsion de tension (9).

3. Détecteur de proximité inductif selon l'une au moins des revendications précédentes,
**caractérisé en ce que**
le détecteur de proximité inductif (1) comporte une première bobine (3) à titre de bobine émettrice (4) et une seconde bobine (11) à titre de bobine réceptrice (12), l'impulsion de courant d'émission circulant à travers la bobine émettrice (4) et la tension d'impulsion résultante de l'impulsion de tension (9) pouvant être mesurée au niveau de la bobine réceptrice (12).

4. Détecteur de proximité inductif selon la revendication 3,
**caractérisé en ce que**
il est prévu des moyens de commutation, la première bobine (3) et la seconde bobine (11) pouvant être branchées en parallèle, ou la première bobine (3) et la seconde bobine (11) pouvant être branchées en série.

5. Détecteur de proximité inductif selon l'une au moins des revendications précédentes,
**caractérisé en ce que**
il est prévu un convertisseur analogique-numérique pour échantillonner l'impulsion de tension, ou il est prévu un convertisseur temps-numérique ou un convertisseur dit Time-to-Digital Converter pour échantillonner l'impulsion de tension, ou
il est prévu un amplificateur (17) entre la bobine (3) et un convertisseur analogique-numérique (16), pour convertir l'impédance et adapter le niveau.

6. Détecteur de proximité inductif selon l'une au moins des revendications précédentes,
**caractérisé en ce que**
au moins la bobine (3) et l'unité de pilotage et d'évaluation (7) sont disposées dans un boîtier métallique (18), au moins une face frontale avec la bobine (3) présentant une face frontale métallique qui est reliée à une enveloppe métallique.

7. Détecteur de proximité inductif selon l'une au moins des revendications précédentes,
**caractérisé en ce que**
l'unité de pilotage et d'évaluation (7) est réalisée pour utiliser au moins une valeur échantillonnée (10) d'au moins une impulsion de tension (9) afin de calculer une propriété d'un objet.

8. Détecteur de proximité inductif selon l'une au moins des revendications précédentes,
**caractérisé en ce que**
l'unité de pilotage et d'évaluation (7) est réalisée pour former et évaluer un signe d'une différence entre au moins une valeur de référence mémorisée dans une mémoire (19) et au moins une valeur échantillonnée (10), afin de constater si l'objet (2) est ferromagnétique ou non.

9. Détecteur de proximité inductif selon l'une au moins des revendications précédentes,
**caractérisé en ce que**
l'unité de pilotage et d'évaluation (7) est réalisée pour évaluer une hauteur d'impulsion, une longueur d'impulsion et/ou des passages par zéro de l'impulsion de tension (9), moyennant quoi l'unité de pilotage et d'évaluation (7) forme le signal de distance (21).

10. Détecteur de proximité inductif selon l'une au moins des revendications précédentes,
**caractérisé en ce que**
l'unité de pilotage et d'évaluation (7) est réalisée pour former une différence entre deux impulsions de tension enregistrées successivement dans le temps, et elle est réalisée pour générer le signal de distance (21) à partir de ladite différence.

11. Détecteur de proximité inductif selon l'une au moins des revendications précédentes,
**caractérisé en ce que**
pour générer une impulsion de courant, une source de tension et une résistance sont utilisées et/ou une résistance est branchée parallèlement à la bobine (3), afin de limiter une hauteur de l'impulsion de tension (9) en vue de protéger l'électronique de pilotage et d'évaluation (7) à l'encontre d'une destruction.

12. Procédé pour la détection d'un objet (2) au moyen d'un détecteur de proximité inductif comportant au moins une bobine (3), dans lequel
au moins une impulsion de courant d'émission est appliquée à la bobine (3) par une unité de pilotage et d'évaluation (7), et l'unité de pilotage et d'évaluation (7) est réalisée pour délivrer un signal de constatation d'objet (8), au moins une impulsion de tension induite (9), générée par l'impulsion de courant d'émission au niveau de la bobine (3), est échantillonnée dans au moins un intervalle à partir ou après l'instant de l'application de l'impulsion de courant d'émission jusqu'à l'instant de la décroissance complète de l'impulsion de tension (9), et des valeurs échantillonnées (10) sont formées de l'impulsion de tension, moyennant quoi l'impulsion de tension (9) est numérisée,
en vue d'une détermination de la distance d'un objet métallique (2), l'unité de pilotage et d'évaluation (7) est réalisée pour évaluer les valeurs échantillonnées (10) d'au moins deux impulsions de tension successives (9), des points d'échantillonnage (20) étant décalés les uns des autres par rapport au début de l'impulsion de tension (9), moyennant quoi la résolution temporelle de l'impulsion de tension (9) est augmentée par le décalage et par une superposition et l'unité de pilotage et d'évaluation (7) est réalisée pour effectuer une intégration numérique dans une fenêtre temporelle à partir ou après le début de l'impulsion de tension (9) ou de l'impulsion de courant d'émission, afin de générer un signal de distance (21),
**caractérisé en ce que**
l'unité de pilotage et d'évaluation (7) est réalisée pour échantillonner au moins une valeur de tension entre deux impulsions de tension (9) et pour former des valeurs échantillonnées (10) de la valeur de tension entre deux impulsions de tension, et l'unité de pilotage et d'évaluation (7) est réalisée pour effectuer à partir de ces valeurs échantillonnées (10) une compensation de décalages et de perturbations à basse fréquence.
